# EUROPEAN PATENT APPLICATION

(11) **EP 4 596 504 A1**
(43) Date of publication of application: **06.08.2025**
(21) Application number: 24820916.5
(22) Date of filing: 31.05.2024
(51) Int. Cl.: C02F 1/36, C02F 1/58, C02F 1/40, C02F 103/34

(54) **APPARATUS FOR DECOMPOSING NON-BIODEGRADABLE MATERIAL USING ULTRASONIC WAVES, AND DECOMPOSITION METHOD OF SAME**

(30) Priority: 20.12.2023 KR 20230186914
(71) Applicant: Fust Lab. Co., Ltd., Yuseong-gu Daejeon 34015 (KR)
(72) Inventor: HWANGBO, Minsung, Yuseong-gu, Daejeon 34127 (KR); KIM, So Yul, Yuseong-gu, Daejeon 34006 (KR); KIM, Jung Mok, Seoul 06234 (KR)
(74) Representative: RGTH
(86) International application number: PCT/KR2024/007419
(87) International publication number: WO 2025/135333

(57) **Abstract**

A non-degradable substance degradation device using an ultrasound according to an embodiment of the present invention may include: a sample inflow unit into which a sample containing a non-degradable substance is introduced; a sample circulation unit having a circulation space connected to communicate with the sample inflow unit, and in which the sample moved through the sample inflow unit is circulated; and an ultrasound vibration unit surrounding at least a part of the sample circulation unit to be spaced apart from an outer surface of the sample circulation unit, and generating an ultrasound and providing the ultrasound to the sample circulated in the sample circulation unit to degrade the non-degradable substance of the sample.

## Description

### [Technical Field]

The present invention relates to a non-degradable substance degradation device using an ultrasound and a degradation method thereof, and more particularly, to a non-degradable substance degradation device which directly provide an ultrasound to a sample containing a non-degradable material such as poly- and per-fluoroalkyl substances (PFAS) to directly degrade the non-degradable substance with a high resolution in a sample circulation unit, and can be easily mass produced because a structure of the device is not complicated, and a degradation method thereof.

### [Background Art]

In recent years, a hazard problem of poly- and per-fluoroalkyl substances (PFAS) which is an environmental pollutant, called "eternal chemical" because the substance is not naturally degraded has been seriously discussed.

The PFAS as a substance in which carbon and fluorine are combined is a type of environmental hormone that affects ecosystems and human hormones. The PFAS is used for fluorine resin coating (pot or frying pan), packing, and waterproofing materials due to characteristics of being resistant to heat or blocking water or oil, and is found in a human environment due to a high residual property and a high accumulative property.

The PFAS causes problems such as carcinogenicity, developmental toxicity, and reproductive toxicity. Moreover, there is a limit in a prior art for removing the PFAS, and there is also a limit in mass production of a degradation device.

In addition, as a prior art for removing the PFAS, there is a nanofiltration electrochemical anode technology. A method for removing a PFHxA contaminated water is attempted, but the method is made at a scale of less than 1 L, so there is a limit in that the method cannot be used in an actual field.

On the other hand, it is possible to remove PFOS significantly as a method using a granular activated carbon technology, but there is a problem in that activated carbon used for removal cannot be safely and appropriately treated.

Alternatively, there is a nanofiltration-photocatalysis oxidation-ultra fine filtration scheme. Although there is a possibility of purifying contaminated water, but there is a hassle that additional measures are required for removing remaining PFOA, such as recycling final waste water.

In other words, there are several prior arts for removing the PFAS, but in fact, degradation and mass production technologies are actually absent.

Therefore, the development of degradation devices and methods that directly remove the PFAS is required.

### [Disclosure]

### [Technical Problem]

An embodiment of the present invention provides a non-degradable substance degradation device which directly provide an ultrasound to a sample containing a non-degradable material such as poly- and per-fluoroalkyl substances (PFAS) to directly degrade the non-degradable substance with a high resolution in a sample circulation unit, and which can be easily mass produced because a structure of the device is not complicated, and a degradation method thereof.

The objects to be solved by the present invention are not limited to the aforementioned object(s), and other object(s), which are not mentioned above, will be apparent to a person having ordinary skill in the art from the following description.

### [Technical Solution]

A non-degradable substance degradation device using an ultrasound according to an embodiment of the present invention may include: a sample inflow unit into which a sample containing a non-degradable substance is introduced; a sample circulation unit having a circulation space connected to communicate with the sample inflow unit, and in which the sample moved through the sample inflow unit is circulated; and an ultrasound vibration unit surrounding at least a part of the sample circulation unit to be spaced apart from an outer surface of the sample circulation unit, and generating an ultrasound and providing the ultrasound to the sample circulated in the sample circulation unit to degrade the non-degradable substance of the sample.

Further, the degradation device according to the embodiment of the present invention may further include a sample outflow unit provided at one side of the sample circulation unit to face the sample inflow unit, and flowing out the sample containing the non-degradable substance degraded by the ultrasound vibration unit in the sample circulation unit.

In addition, the degradation device according to the embodiment of the present invention may further include a cooling unit which is provided to penetrate centers of the sample inflow unit, the sample circulation unit, and the sample outflow unit, and in which a cooling substance for the sample circulated in the sample circulation unit along a movement path formed therein.

Further, according to the embodiment of the present invention, the ultrasound vibration unit may include a first vibration member having a cross section with a hollow semicircular shape, and provided to be spaced apart from a part of an outer surface of the sample circulation unit, and a second vibration member having the cross section with the hollow semicircular shape to face the first vibration member, and provided to be spaced apart from the other part on the outer surface of the sample circulation unit, and forming a hollow circular cross section jointly with the first vibration member.

Further, according to the embodiment of the present invention, the first vibration member and the second vibration member may be provided as piezoelectric ceramics.

Further, according to the embodiment of the present invention, a frequency range of the ultrasound irradiated into the sample circulation unit by the ultrasound vibration unit may be 350 to 700 kHz.

Further, according to the embodiment of the present invention, inclination parts may be provided at both end portions forming the circulation space of the sample circulation unit, which face a diagonal direction to concentrate a disturbed negative pressure when the sample is circulated on a center.

In addition, according to the embodiment of the present invention, an inclination angle of the inclination part may be 10 to 80 degrees.

Meanwhile, a degradation method of a non-degradable substance degradation device using an ultrasound according to an embodiment of the present invention may include: a sample inflow step of introducing, by a sample inflow unit, a sample containing a non-degradable substance; a sample circulation step of circulating, by a sample circulation unit connected to communicate with the sample inflow unit, the sample moved from the sample inflow unit in a circulation space; and a degradation step of providing, by an ultrasound vibration unit surrounding at least a part of the sample circulation unit, an ultrasound to the sample in the sample circulation unit to the sample in the sample circulation unit, and degrading the non-degradable substance contained in the sample.

In addition, the degradation method according to the embodiment of the present invention may further include an outflow step executed after the degradation step, and flowing out, by a sample outflow unit provided at one side of the sample circulation unit to face the sample inflow unit, a sample containing the non-degradable substance degraded by the ultrasound vibration unit in the sample circulation unit.

In addition, the degradation method according to the embodiment of the present invention may further include a cooling step executed simultaneously upon the sample circulation step, and cooling the sample which goes through the sample circulation step by using a cooling substance moved along a movement path formed inside a cooling unit penetrating a center of the sample circulation unit.

Further, according to the embodiment of the present invention, a frequency range of the ultrasound delivered to the sample in the sample circulation unit through the ultrasound vibration unit upon the degradation step may be 350 to 700 kHz.

Further, according to the embodiment of the present invention, the ultrasound vibration unit generating the ultrasound upon the degradation step may include a first vibration member having a cross section with a hollow semicircular shape, and provided to be spaced apart from a part of an outer surface of the sample circulation unit, and a second vibration member having the cross section with the hollow semicircular shape to face the first vibration member, and provided to be spaced apart from the other part on the outer surface of the sample circulation unit, and forming a hollow circular cross section jointly with the first vibration member, and the first vibration member and the second vibration member may be provided as piezoelectric ceramics.

Meanwhile, a cleaning method of a cleaning device using an ultrasound according to an embodiment of the present invention may include an inflow step of introducing, by an inflow unit, a cleaning target; a circulation step of circulating, by a circulation unit connected to the inflow unit, the cleaning target delivered from the inflow unit in a circulation space in the circulation unit; a cleaning step of delivering, by an ultrasound vibration unit surrounding at least a part of the circulation unit, an ultrasound to the cleaning target in the circulation unit, and cleaning the cleaning target; and an outflow step of flowing out, by an outflow unit provided at one side of the circulation unit to face, the cleaning target cleaned by the ultrasound vibration unit in the circulation unit.

Further, according to the embodiment of the present invention, the cleaning target may be a substrate type including a semiconductor wafer.

### [Advantageous Effects]

According to an embodiment of the present invention, an ultrasound is directly provided to a sample containing a non-degradable material such as poly- and per-fluoroalkyl substances (PFAS) to directly degrade the non-degradable substance with a high resolution in a sample circulation unit, and the non-degradable substance degradation device can be easily mass produced because a structure of the device is not complicated.

### [Description of Drawings]

FIG. 1 is a perspective view of a non-degradable substance degradation device using an ultrasound according to an embodiment of the present invention.
FIG. 2 is a schematic perspective view illustrating an internal structure of the degradation device of FIG. 1 to be projected.
FIG. 3 is a cross-sectional view illustrating an internal configuration of the degradation device illustrated in FIG. 2.
FIG. 4 is a perspective view of an ultrasound vibration unit illustrated in FIG. 1.
FIG. 5 is a graph showing a resolution result according to a frequency range of an ultrasound generated from the ultrasound vibration unit in the non-degradable substance degradation device using an ultrasound according to an embodiment of the present invention.
FIG. 6 is a flowchart of a degradation method of a non-degradable substance degradation device according to an embodiment of the present invention.

### [Best Mode]

Advantages and/or features of the present invention, and a method for achieving the advantages and/or features will become obvious with reference to embodiments to be described below in detail together with the accompanying drawings.

However, the present invention is not limited to the embodiments set forth below, and will be embodied in various different forms. The embodiments are just for rendering the disclosure of the present invention complete and are set forth to provide a complete understanding of the scope of the invention to a person with ordinary skill in the technical field to which the present invention pertains, and the present invention will only be defined by the scope of the claims. Like reference numerals refer to like elements throughout the specification.

Embodiments of the present invention will now be described in detail with reference to the accompanying drawings.

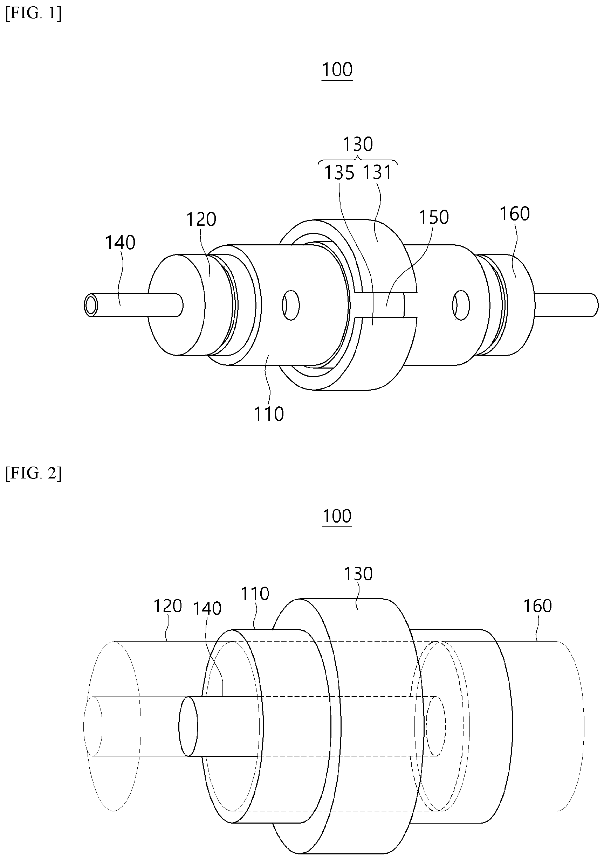

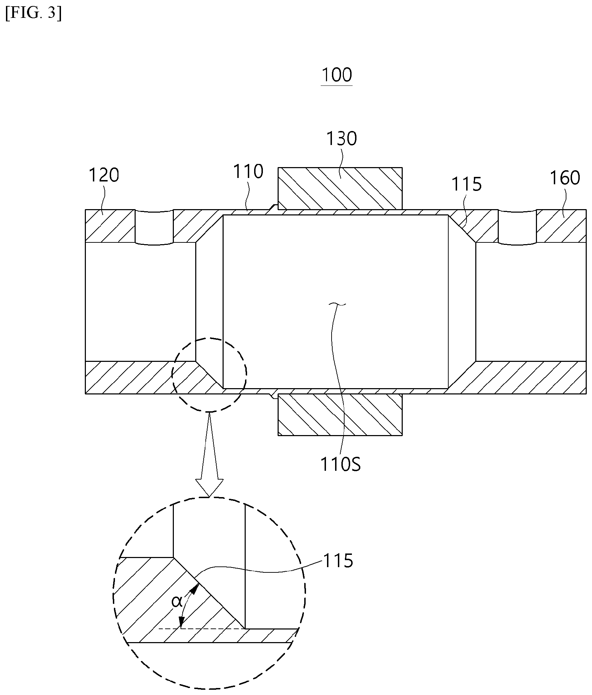

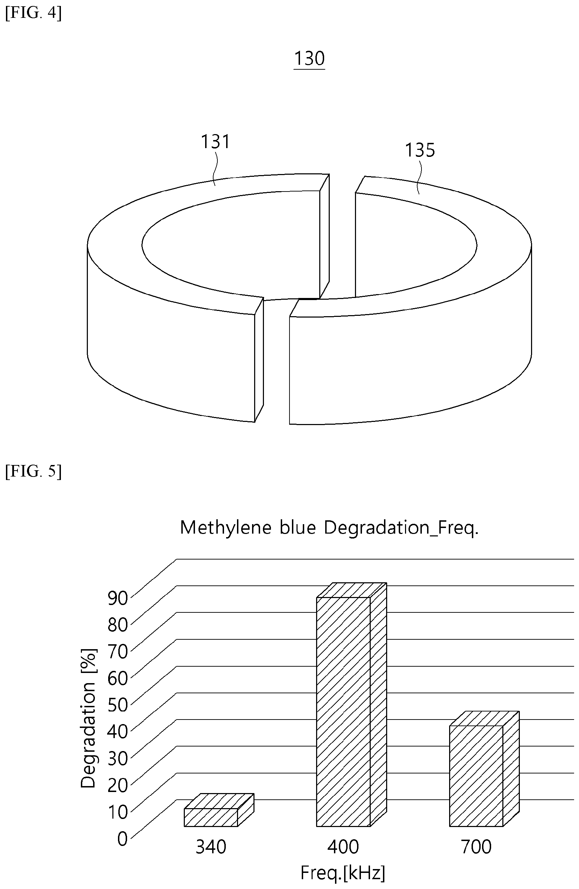

FIG. 1 is a perspective view of a non-degradable substance degradation device using an ultrasound according to an embodiment of the present invention, FIG. 2 is a schematic perspective view illustrating an internal structure of the degradation device of FIG. 1 to be projected, FIG. 3 is a cross-sectional view illustrating an internal configuration of the degradation device illustrated in FIG. 2, and FIG. 4 is a perspective view of an ultrasound vibration unit illustrated in FIG. 1.

Referring to FIGS. 1 to 3, the non-degradable substance degradation device 100 using an ultrasound according to an embodiment of the present invention as a device that degrades a non-degradable substance such as PFAS using the ultrasound may include a sample inflow unit 120, a sample circulation unit 110, an ultrasound vibration unit 130, a sample outflow unit 160, and a cooling unit 140.

Here, first, the sample inflow unit 120 of the embodiment through which a sample containing the non-degradable substance is introduced may be provided in a hollow cylindrical shape as illustrated in FIG. 1. Although not illustrated, an inlet through the sample is introduced may be provided at one side portion of the sample inflow unit 120, and the sample introduced through the inlet may be delivered to a next sample circulation unit 110 through a movement path formed in the sample inflow unit 120.

As illustrated in FIGS. 1 and 2, the sample circulation unit 110 of the embodiment may be connected to communicate with the sample inflow unit 120, and may include a circulation space 110S in which the sample moved through the sample inflow unit 120 is circulated.

As schematically illustrated in FIGS. 2 and 3, the sample circulation unit 110 may be provided substantially in a hollow cylindrical shape, and one end portion of the sample inflow unit 120 may be provided at one side of the sample circulation unit 110, and the sample inflow unit 120 and the sample circulation unit 110 may have a communication structure. The sample inflow unit 120, the sample circulation unit 110, and the sample outflow unit 160 may be formed integrally.

That is, the sample introduced through the inlet of the sample introduction unit 120 may be delivered to the sample circulation unit 110, and may go through a degradation process while being circulated in the circulation space 110S of the sample circulation unit 110.

Referring to FIG. 3, inclination parts 115 may be provided at both end portions forming the circulation space 110S of the sample circulation unit 110, which face a diagonal direction. That is, if the circulation space 110S of the sample circulation unit 110 substantially has a hollow cylindrical shape based on FIG. 3, both end portions have a shape in which an inner diameter gradually decreases, so the inclination part 115 may be provided in the sample circulation unit 110.

A negative pressure which is disturbed when the sample is circulated in the sample circulation unit 110 may be concentrated on a center through the inclination part 115, thereby increasing degradation efficiency.

Here, an inclination angle α of the inclination part 115 may be 10 to 80 degrees based on an inner surface forming the circulating space 110S of the sample circulation unit 110. However, the inclination angle α of the inclination part 115 is not limited thereto.

Meanwhile, as illustrated in FIGS. 1 to 4, the ultrasound vibration unit 130 of the embodiment is provided while surrounding the sample circulation unit 110 to be spaced apart from a central part of the sample circulation unit 110, and generates the ultrasound in a direction of the circulation space 110S of the sample circulation unit 110 and provides the ultrasound to the sample which is circulated in the sample circulation unit 110 to degrade the non-degradable material included in the sample.

As illustrated in FIGS. 2 and 4, the ultrasound vibration unit 130 may include a first vibration member 131 having a cross section with a hollow semicircular shape, and provided to be spaced apart from a part of an outer surface of the sample circulation unit 110, and a second vibration member 135 having the cross section with the hollow semicircular shape to face the first vibration member 131, and provided to be spaced apart from the other part on the outer surface of the sample circulation unit 110, and forming a hollow circular cross section jointly with the first vibration member 131.

That is, the first vibration member 131 and the second vibration member 135 substantially have a circular ring shape, but have a shape in which respective end portions are spaced apart from each other, and are provided as piezoelectric ceramics to generate the ultrasound and provide the generated ultrasound into the sample circulation unit 110.

As described above, the first vibration member 131 and the second vibration member 135 are provided to be spaced apart from each other on the outer surface of the sample circulation unit 110 to protect an internal electrode 150 provided in the sample circulation unit 110, and moreover, has a structure of being spaced apart from the internal electrode 150 by a predetermined interval, thereby generating uniform energy.

However, in the embodiment, it is described that the ultrasound vibration unit 130 includes the first vibration member 131 and the second vibration member 135 which have a semicircular shape, but is not limited thereto, and may have a ring shape in which three or more vibration members are spaced apart from each other, of course. A frequency range of the ultrasound irradiated into the circulation space 110S of the sample circulation unit 110 by the ultrasound vibration unit 130 may be, for example, 350 to 700 kHz.

This will be described with reference to FIG. 5.

FIG. 5 is a graph showing a resolution result according to a frequency range of an ultrasound generated from the ultrasound vibration unit in the non-degradable substance degradation device using an ultrasound according to an embodiment of the present invention.

As illustrated, it can be seen that when the ultrasound generated from the ultrasound vibration unit 130 is, for example, 340 kHz, a resolution of methylene blue is approximately 7.1%, and when the ultrasound is 700 kHz, the resolution of methylene blue is approximately 38%, but when the ultrasound is 400 kHz, the resolution of methylene blue is 85.6%.

That is, it can be seen that when the frequency of the ultrasound generated from the ultrasound vibration unit 130 is 350 to 700 kHz, the ultrasound may have an excellent resolution, and in particular, it can be seen that the ultrasound may have a best resolution at 400 kHz.

Meanwhile, referring to FIGS. 1 and 2, the sample inflow unit 160 of the embodiment is provided at one side of the sample circulation unit 110 to face the sample inflow unit 120, and may flow out the sample containing the non-degradable substance degraded by the ultrasound vibration unit 130 in the sample circulation unit 110.

The sample outflow unit 160 may have the hollow cylindrical shape corresponding to the sample inflow unit 120, and although not illustrated, the outflow unit is provided at one side to discharge the degraded sample to the outside.

Meanwhile, as illustrated in FIGS. 1 and 2, the non-degradable substance degradation device 100 of the embodiment may further include the cooling unit 140 for cooling to increase the resolution.

As schematically illustrated in FIGS. 1 and 2, the cooling unit 140 of the embodiment may be provided to penetrate centers of the sample inflow unit 120, the sample circulation unit 110, and the sample outflow unit 160, and in a cooling substance for cooling the sample circulated in the sample circulation unit 110 may be moved along a movement path formed in the cooling unit 140.

Through this, the sample circulated in the circulation space 110S of the sample circulation unit 110 and the cooling substance of the cooling unit 140 exchange heat, so a temperature of the sample may be lowered, and through this, the ultrasound is provided to the sample of which temperature is lowered from the ultrasound vibration unit 130, and as a result, the non-degradable substance in the sample may be better degraded.

Meanwhile, hereinafter, a degradation method of the non-degradable substance degradation device 100 having the above-described configuration will be described with reference to a drawing.

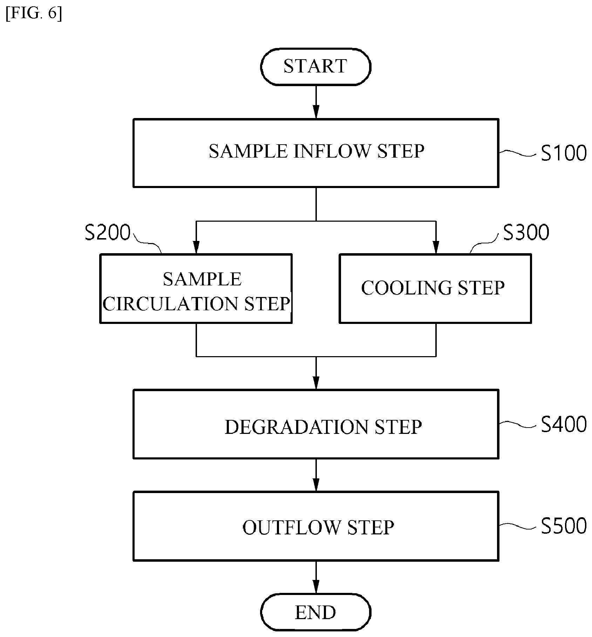

FIG. 6 is a flowchart of a degradation method of a non-degradable substance degradation device according to an embodiment of the present invention.

As illustrated, the degradation method of the non-degradable substance degradation device 100 of the embodiment may include a sample inflow step S100, a sample circulation step S200, a degradation step S400, and an outflow step S500. Moreover, the degradation method may further include a cooling step S300 which is executable simultaneously upon the sample circulation step S200.

When respective steps are described, first, upon the sample inflow step S100 of the embodiment, a sample containing a non-degradable substance may be introduced through a sample inflow unit 120.

Upon the sample circulation step S200 of the embodiment, the sample moved from the sample inflow unit 120 through a sample circulation unit 110 connected to communicate with the sample inflow unit 120 may be circulated inside a circulation space 110S.

At this time, a cooling step S300 may be executed jointly, and upon the cooling step S300, a sample may be cooled which goes through the sample circulation step S200 by using a cooling substance moved along a movement path formed inside a cooling unit 140 which penetrates a center of the sample circulation unit 110.

Upon the degradation step S400 of the embodiment, the non-degradable substance contained in the sample may be degraded by providing an ultrasound of 350 to 700 kHz to the sample in the sample circulation unit 110 through an ultrasound vibration unit 130 surrounding the sample circulation unit 110.

Next, upon the outflow step S500 of the embodiment, the sample containing the non-degradable substance degraded by the ultrasound vibration unit 130 in the sample circulation unit 110 may flow out through the sample outflow unit 160.

As described above, according to an embodiment of the present invention, for example, the ultrasound is directly provided to the sample containing the non-degradable substance such as poly- and per-fluoroalkyl substances (PFAS) to directly degrade the non-degradable substance with a high resolution in the sample circulation unit 110, and the non-degradable substance degradation device can be easily mass produced because the structure of the device is not complicated.

Meanwhile, hereinafter, a cleaning method of a cleaning device using an ultrasound according to another embodiment of the present invention will be described. However, a description of contents substantially corresponding to the degradation method of the degradation device according to an embodiment described above will be omitted.

The cleaning method of the cleaning device according to another embodiment of the present invention may include an inflow step of introducing a cleaning target through an inflow unit, a circulation step of circulating the cleaning target delivered from the inflow unit through a circulation unit connected to the inflow unit in a circulation space in the circulation unit, a cleaning step of delivering an ultrasound to the cleaning target in the circulation unit through an ultrasound vibration unit surrounding at least a part of the circulation unit, and cleaning the cleaning target, and an outflow step of flowing out the cleaning target cleaned by the ultrasound vibration unit in the circulation unit through an outflow unit provided at one side of the circulation unit to face the inflow unit.

Here, the cleaning target may be a substrate type including a semiconductor wafer.

As such, in the case of the embodiment, cleaning of the semiconductor wafer may directly be efficiently and accurately performed by using the ultrasound.

Although the detailed embodiments of the present invention have been described up to now, various modifications of the present invention can be made without departing from the scope of the present invention. Therefore, the scope of the present invention should not be limited to the embodiments and should be defined by the appended claims and equivalents to the appended claims.

Although the present invention has been described by the limited embodiments and drawings, the present invention is not limited to the embodiments and various modifications and transformations can be made by those skilled in the art from the disclosure. The spirit of the present invention should be construed based on the following claims and all equivalents or equivalent modifications thereto should be construed as falling within the scope of the spirit of the present invention.

## Claims

1. A non-degradable substance degradation device using an ultrasound, comprising:
a sample inflow unit into which a sample containing a non-degradable substance is introduced;
a sample circulation unit having a circulation space connected to communicate with the sample inflow unit, and in which the sample moved through the sample inflow unit is circulated; and
an ultrasound vibration unit surrounding at least a part of the sample circulation unit to be spaced apart from an outer surface of the sample circulation unit, and generating an ultrasound and providing the ultrasound to the sample circulated in the sample circulation unit to degrade the non-degradable substance of the sample.

2. The non-degradable substance degradation device using an ultrasound of claim 1, further comprising:
a sample outflow unit provided at one side of the sample circulation unit to face the sample inflow unit, and flowing out the sample containing the non-degradable substance degraded by the ultrasound vibration unit in the sample circulation unit.

3. The non-degradable substance degradation device using an ultrasound of claim 2, further comprising:
a cooling unit which is provided to penetrate centers of the sample inflow unit, the sample circulation unit, and the sample outflow unit, and in which a cooling substance for the sample circulated in the sample circulation unit along a movement path formed therein.

4. The non-degradable substance degradation device using an ultrasound of claim 1, wherein the ultrasound vibration unit includes
a first vibration member having a cross section with a hollow semicircular shape, and provided to be spaced apart from a part of an outer surface of the sample circulation unit, and
a second vibration member having the cross section with the hollow semicircular shape to face the first vibration member, and provided to be spaced apart from the other part on the outer surface of the sample circulation unit, and forming a hollow circular cross section jointly with the first vibration member.

5. The non-degradable substance degradation device using an ultrasound of claim 4, wherein the first vibration member and the second vibration member are provided as piezoelectric ceramics.

6. The non-degradable substance degradation device using an ultrasound of claim 4, wherein a frequency range of the ultrasound irradiated into the sample circulation unit by the ultrasound vibration unit is 350 to 700 kHz.

7. The non-degradable substance degradation device using an ultrasound of claim 1, wherein inclination parts are provided at both end portions forming the circulation space of the sample circulation unit, which face a diagonal direction to concentrate a disturbed negative pressure when the sample is circulated on a center.

8. The non-degradable substance degradation device using an ultrasound of claim 7, wherein an inclination angle of the inclination part is 10 to 80 degrees.

9. A degradation method of a non-degradable substance degradation device using an ultrasound, comprising:
a sample inflow step of introducing, by a sample inflow unit, a sample containing a non-degradable substance;
a sample circulation step of circulating, by a sample circulation unit connected to communicate with the sample inflow unit, the sample moved from the sample inflow unit in a circulation space; and
a degradation step of providing, by an ultrasound vibration unit surrounding at least a part of the sample circulation unit, an ultrasound to the sample in the sample circulation unit to the sample in the sample circulation unit, and degrading the non-degradable substance contained in the sample.

10. The degradation method of a non-degradable substance degradation device using an ultrasound of claim 9, further comprising:
an outflow step executed after the degradation step, and flowing out, by a sample outflow unit provided at one side of the sample circulation unit to face the sample inflow unit, a sample containing the non-degradable substance degraded by the ultrasound vibration unit in the sample circulation unit.

11. The degradation method of a non-degradable substance degradation device using an ultrasound of claim 2, further comprising:
a cooling step executed simultaneously upon the sample circulation step, and cooling the sample which goes through the sample circulation step by using a cooling substance moved along a movement path formed inside a cooling unit penetrating a center of the sample circulation unit.

12. The degradation method of a non-degradable substance degradation device using an ultrasound of claim 1, wherein a frequency range of the ultrasound delivered to the sample in the sample circulation unit through the ultrasound vibration unit upon the degradation step is 350 to 700 kHz.

13. The degradation method of a non-degradable substance degradation device using an ultrasound of claim 12, wherein the ultrasound vibration unit generating the ultrasound upon the degradation step includes
a first vibration member having a cross section with a hollow semicircular shape, and provided to be spaced apart from a part of an outer surface of the sample circulation unit, and
a second vibration member having the cross section with the hollow semicircular shape to face the first vibration member, and provided to be spaced apart from the other part on the outer surface of the sample circulation unit, and forming a hollow circular cross section jointly with the first vibration member, and
the first vibration member and the second vibration member are provided as piezoelectric ceramics.

14. A cleaning method of a cleaning device using an ultrasound, comprising:
an inflow step of introducing, by an inflow unit, a cleaning target;
a circulation step of circulating, by a circulation unit connected to the inflow unit, the cleaning target delivered from the inflow unit in a circulation space in the circulation unit;
a cleaning step of delivering, by an ultrasound vibration unit surrounding at least a part of the circulation unit, an ultrasound to the cleaning target in the circulation unit, and cleaning the cleaning target; and
an outflow step of flowing out, by an outflow unit provided at one side of the circulation unit to face, the cleaning target cleaned by the ultrasound vibration unit in the circulation unit.

15. The cleaning method of a cleaning device using an ultrasound of claim 14, wherein the cleaning target is a substrate type including a semiconductor wafer.
